# EUROPEAN PATENT SPECIFICATION

(11) **EP 2 879 162 B1**
(45) Date of publication and mention of the grant of the patent: **29.07.2020**
(21) Application number: 13822788.9
(22) Date of filing: 29.07.2013
(51) Int. Cl.: H01L 23/473, H01L 21/67, F28F 13/06

(54) **FLOW PATH MEMBER, AND HEAT EXCHANGER AND SEMICONDUCTOR MANUFACTURING DEVICE USING SAME**
STRÖMUNGSWEGELEMENT SOWIE WÄRMETAUSCHER UND VORRICHTUNG ZUR HALBLEITERHERSTELLUNG DAMIT
ORGANE DE CHEMIN D'ÉCOULEMENT ET ÉCHANGEUR DE CHALEUR ET DISPOSITIF DE FABRICATION DE SEMI-CONDUCTEURS L'UTILISANT

(30) Priority: 27.07.2012 JP 2012167200
(43) Date of publication of application: 03.06.2015
(73) Proprietor: Kyocera Corporation, Kyoto-shi, Kyoto 612-8501 (JP)
(72) Inventor: SEKIGUCHI,Keiichi, Kyoto-shi Kyoto 612-8501 (JP); FUJIO,Kazuhiko, Kyoto-shi Kyoto 612-8501 (JP); ISHIMINE,Yuusaku, Kyoto-shi Kyoto 612-8501 (JP)
(74) Representative: Viering, Jentschura & Partner mbB Patent- und Rechtsanwälte
(86) International application number: PCT/JP2013/070524
(87) International publication number: WO 2014/017661

(56) References cited:
- JP-A- H11 329 926
- JP-A- S62 229 947
- JP-A- 2001 237 357
- JP-A- 2003 121 086
- JP-A- 2006 270 084
- US-A1- 2004 187 787
- US-A1- 2007 130 769
- US-A1- 2007 137 843
- US-A1- 2011 303 641

## Description

### Technical Field

The present invention relates to a flow path member, and a heat exchanger and a semiconductor manufacturing device using the flow path member.

### Background Art

In general, a flow path member that includes a flow path therein is capable of performing heat exchange with another member that is in contact with the flow path member by causing a fluid to flow through the flow path and, thereby it is possible to regulate (control) a temperature of the another member that is in contact with the flow path member.

For example, PTL1 discloses a semiconductor apparatus that includes a semiconductor component which includes at least one semiconductor element and a pair of lead frames between which the semiconductor element is interposed and which is molded from a resin by exposing an outer surface of the lead frame, and a ceramic tube which is joined to the outer surface of the pair of lead frames by a joining metal and includes a refrigerant passage.

### Citation List

### Patent Literature

PTL 1: Japanese Unexamined Patent Application Publication No. 2008-103623

JP H11-329926 A discloses that inside a cooling plate, first and second cooling pipes are provided at the center region of a substrate cooling surface and a periphery region, respectively (cf. Abstract).

### Summary of Invention

### Technical Problem

However, a problem arises in that, in the semiconductor device of PTL 1, in a case where pressure of the fluid is set to be high so as to improve heat exchange efficiency between heat generated by the semiconductor element and a fluid which is a refrigerant flowing through the refrigerant passage, stress is concentrated between corners of particularly adjacent refrigerant passages and thus the refrigerant passages are likely to be damaged.

Therefore, the present invention aims to provide a flow path member, and a heat exchanger and a semiconductor manufacturing device using the flow path member, of which reliability is improved.

### Solution to Problem

The present invention provides a flow path member according to claim 1, a heat exchanger according to claim 3, and a semiconductor manufacturing device according to claim 4. Further embodiments of the present invention are described in dependent claims.

### Advantageous Effects of Invention

In the flow path member according to the present invention, the stress concentration between corners of the adjacent flow path openings on the cut plane obtained by cutting from the first wall section to the second wall section is reduced and it is possible to suppress the damage to the flow path. Therefore the reliability is improved.

In addition, in the heat exchanger according to the present invention, it is possible to achieve a heat exchanger which has high heat exchange efficiency and of which the reliability is improved.

In addition, in the semiconductor manufacturing device according to the present invention, it is possible to achieve a semiconductor manufacturing device which is capable of manufacturing a highly reliable semiconductor element.

### Brief Description of Drawings

Fig. 1 is an external perspective view schematically illustrating a state of being cut from a first wall section to the second wall section as an example of a flow path member which is not part of the present invention.
Fig. 2 is an external perspective view schematically illustrating a state of being cut from the first wall section to the second wall section as another example of a flow path member which is not part of the present invention.
Fig. 3 is an external perspective view schematically illustrating a state of being cut from the first wall section to the second wall section as still another example of the flow path member which is not part of the present invention.
Fig. 4 is an external perspective view schematically illustrating a state of being cut from the first wall section to the second wall section as still another example of the flow path member according to the present invention, (a) illustrates an example in which the flow paths are displaced gradually closer to the first wall section side approaching the center than at the opposite ends, and (b) illustrates an example in which the flow paths are displaced gradually closer to the second wall section side approaching the center than at the opposite ends.
Fig. 5 is an external perspective view schematically illustrating a state of being cut from the first wall section to the second wall section as still another example of the flow path member which is not part of the present invention.
Fig. 6 shows cross-sectional views illustrating a cross section in parallel to the first wall section and the second wall section as still another example of the flow path member which is not part of the present invention, (a) is a meandering flow path, and (b) is a spiralling flow path.
Fig. 7 is a view illustrating an example of a semiconductor manufacturing device including an heat exchanger.

### Description of Embodiments

Hereinafter, examples of a flow path member according to the embodiment of the present invention will be described.

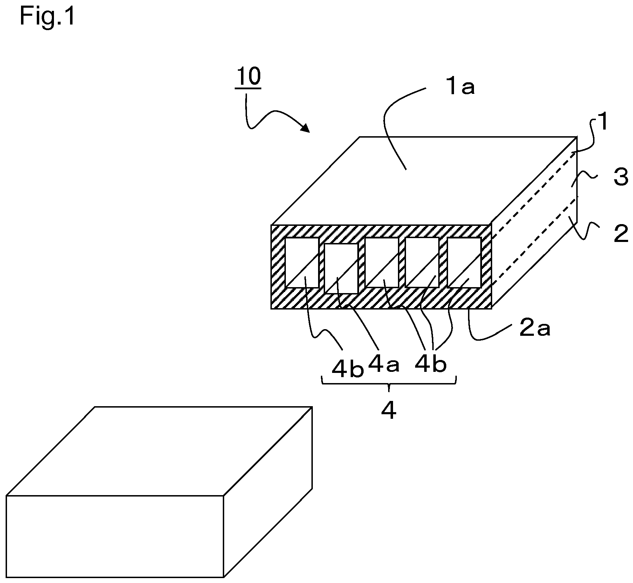

Fig. 1 is an external perspective view schematically illustrating a state of being cut from a first wall section to the second wall section as an example of a flow path member which is not part of the present invention. The same configuration in the following drawings is described by the same reference signs.

A flow path member 10 illustrated in Fig. 1 includes a first wall section 1, a second wall section 2, and a third wall section 3 that is provided between the first wall section 1 and the second wall section 2. An internal section that is configured by the first wall section 1, the second wall section 2, and the third wall section 3 becomes a flow path through which a fluid flows and a plurality of flow path openings 4 of the flow path are arranged in one direction on a cut plane obtained by cutting from the first wall section 1 to the second wall section 2 (hereinafter, simply referred to as a cut plane). Here, it is preferable that a cross-sectional shape of the flow path opening 4 be a polygon and particularly a square.

In the flow path member 10 one flow path opening 4a of two adjacent flow path openings 4a and 4b is disposed to be more displaced than the other flow path opening 4b either toward the first wall section 1 side or toward the second wall section 2 side.

Thus, since a distance between corners of adjacent flow path openings 4 (in other words, adjacent flow paths on the cut plane) becomes long and stress concentration occurring between the corners of the adjacent flow paths can be reduced, it is possible to suppress damage to the flow path. Thus, reliability of the flow path member 10 is improved. In the flow path member 10 according to the present example, the flow path may be configured to have a plurality of flow paths, further may be configured to have one flow path as a whole, and a plurality of the flow path openings 4 may be arranged in one direction on an arbitrary cut plane. Accordingly, hereinafter, when there is no specific description, in description of adjacent flow path openings 4 on the cut plane, the flow paths are adjacent in some cases.

Here, in a method of measuring a length of displacement of the flow path openings 4 from each other, the cross-sectional shape illustrated in Fig. 1 is described as an example. First, with a flow path opening 4 that is closest to a main surface 1a of the first wall section 1 or a main surface 2a of the second wall section 2 as a reference, the length of displacement of the other flow path openings 4 may be measured. To be more exact, according to Fig. 1, with the second flow path opening 4 from the left which is closest to the main surface 2a side as a reference, differences from the other flow path openings 4 may be measured. Here, when a perpendicular line to the main surface 2a is drawn from the main surface 2a to the center on a line connecting the opposite corners of each of the flow path openings 4 in a width direction on the second wall section 2 side, a difference of the distances of the flow path openings 4 is the length of the displacement. It is possible to measure the length of the displacement on the cut plane of the flow path member 10 using a known optical microscope, microscope, or the like. In order to reduce the stress concentration between the corners of the adjacent flow path openings 4, it is preferable that 0.01 mm or more of the length of the displacement be secured. In addition, in the flow path member 10 illustrated in Fig. 1, the displacement of the flow path means the displacement of the flow path in a direction either toward the first wall section 1 side or toward the second wall section 2 side and the same is true for the following drawings.

Here, the flow path member 10 is assumed to be a flow path through which a highly corrosive gas or liquid flows, and thus it is preferable that the flow path member 10 be formed of ceramics such that the flow path member 10 has a good durability or corrosion resistance and is good in insulation. The material examples of the ceramics can include alumina, zirconia, silicon nitride, aluminum nitride, silicon carbide, cordierite, boron carbide, mullite, or a compound thereof.

Particularly, it is preferable that the flow path member 10 according to the present example be formed of a silicon carbide sintered body with silicon carbide as a main component. Here, the main component means a component which is 80% by weight or more with respect to 100% by weight of the entire components that configures a sintered body. When the flow path member 10 according to the present example is formed of the silicon carbide sintered body with the silicon carbide as the main component, the flow path member 10 has high thermal conductivity in addition to the good durability or corrosion resistance, and thus the heat exchange efficiency is improved. In addition, since the silicon carbide sintered body has lower specific gravity than other ceramics, for example, alumina, it is possible to achieve a light weight in a case where a large-sized flow path member 10 is needed.

Samples with predetermined sizes are cut out from the flow path member 10 and it is possible to check the components of the flow path member 10 by an X-ray diffraction method. In addition, it is possible to check the content through performing an energy dispersive X-ray (EDS) analysis by a scanning electron microscope (SEM). In addition, it is possible to check the content by an ICP emission spectrometry or an X-ray fluorescence spectrometry.

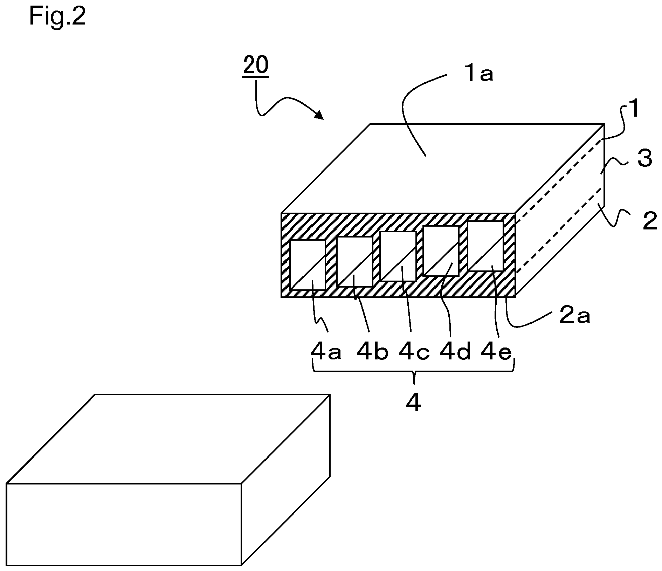

Fig. 2 is an external perspective view schematically illustrating a state of being cut from the first wall section to the second wall section as another example of a flow path member which is not part of the present invention.

In the flow path member 20 illustrated in Fig. 2, for all of the plurality of flow path openings 4 on the cut plane, one of the adjacent flow path openings 4 is disposed to be more displaced either toward the first wall section 1 side or toward the second wall section 2 side than the other. That is, in the flow path member 20 illustrated in Fig. 2, when the flow path openings 4a and 4b are viewed, the flow path opening 4b is displaced toward the first wall section 1 side, when the flow path openings 4b and 4c are viewed, the flow path opening 4c is displaced toward the first wall section 1 side, when the flow path openings 4c and 4d are viewed, the flow path opening 4d is displaced toward the first wall section 1 side, and when the flow path openings 4d and 4e are viewed, the flow path opening 4e is displaced toward the first wall section 1 side.

According to such a configuration, it is possible to further reduce the stress concentration between the corners of all the adjacent flow paths on the cut plane. Thus, since it is possible to further suppress damage to the flow path, it is possible to further improve the reliability of the flow path member 20.

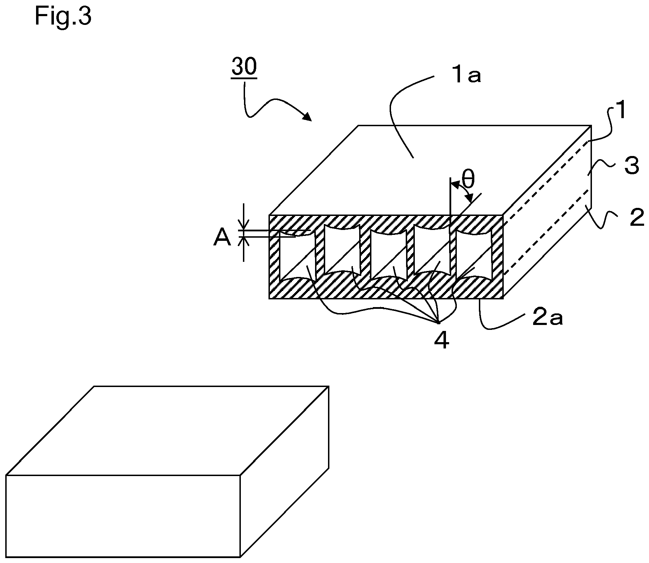

Fig. 3 is an external perspective view schematically illustrating a state of being cut from the first wall section to the second wall section as still another example of the flow path member which is not part of the present invention.

In the flow path member 30 according to the present embodiment illustrated in Fig. 3, a central portion of at least one of the first wall section 1 and the second wall section 2 which configures the flow path is curved toward the flow path side. Fig. 3 illustrates an example in which both central portions of the first wall section 1 and the second wall section 2 are curved toward the flow path side.

According to such a configuration, it is possible to widen a surface area of the flow path. Thus, it is possible to improve the heat exchange efficiency between the member as the heat exchange target and a fluid. Further, for example, in Fig. 3, an angle θ on a corner portion between the first wall section 1 and the third wall section 3 in the flow path is an acute angle. Therefore, compared to a case where the central portion of the first wall section 1 or the second wall section 2 which configures the flow path is not curved toward the flow path, it is possible to cause a direction of the stress produced on the corner not to be toward the corner of the adjacent flow path but to be toward the first wall section 1 side. Accordingly, the stress concentration between the corners of the adjacent flow paths is reduced and it is possible to suppress damage to the flow path. Therefore, the reliability of the flow path member 30 is improved.

The central portion described here indicates a center part when the width of the flow path opening 4 is equally divided into three parts on the cut plane. In addition, a degree of the curvature of the first wall section 1 or the second wall section 2 toward the flow path is represented, for example, by a distance from a line connecting corners of the flow path opening 4 on the first wall section 1 side to each other to an end of a perpendicular line at a portion where the first wall section 1 is curved most toward the flow path side as illustrated by the portion A illustrated in Fig. 3. It is possible to measure the degree of the curvature on the cut plane of the flow path member 30 using the known optical microscope or microscope. It is preferable that the degree of the curvature be 0.01 mm or more in order for the direction of the stress to be toward the first wall section 1 or the second wall section 2.

In addition, it is preferable that the flow path opening 4 be formed to be within a range of 80% to 99.8% with respect to a height of the flow path opening 4 (distance between the center of a line connecting corners on the first wall section 1 side in the width direction and the center of a line connecting corners on the second wall section 2 side in the width direction in a single flow path opening 4).

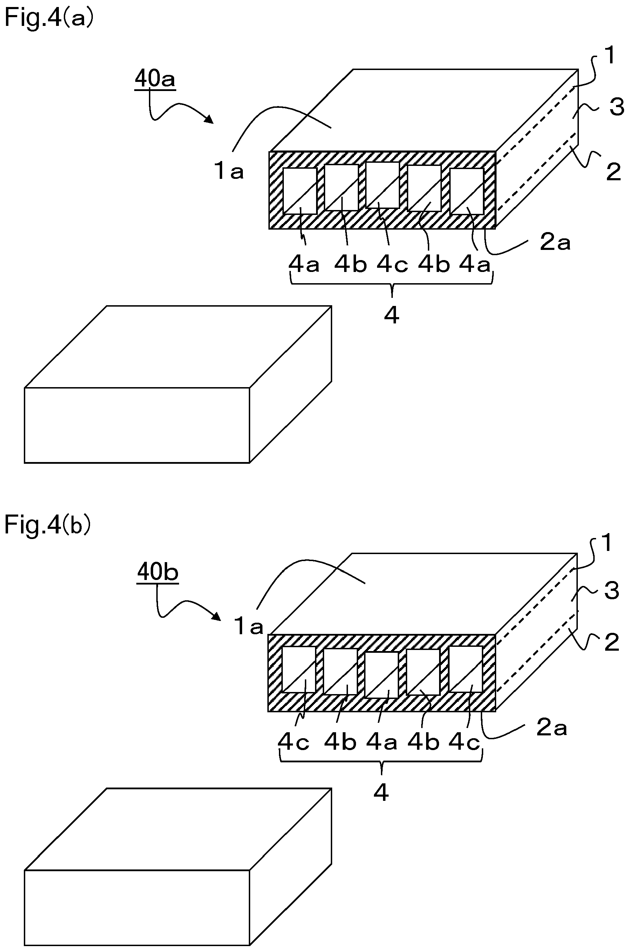

Fig. 4 is an external perspective view schematically illustrating a state of being cut from the first wall section to the second wall section as an example of the flow path member according to the present invention, (a) illustrates an example in which the flow paths are displaced gradually closer to the first wall section side approaching the center than at the opposite ends, and (b) illustrates an example in which the flow paths are displaced gradually closer to the second wall section side approaching the center than at the opposite ends.

In the flow path member 40 according to the present invention illustrated in Fig. 4, when all of the plurality of flow path openings 4 on the cut plane are viewed, the flow path openings 4 are disposed to be displaced gradually closer either to the first wall section 1 side or the second wall section 2 side approaching the center than at opposite ends. According to such a configuration, it is possible to reduce the stress concentration between the corners of the adjacent flow paths in all of the flow paths, and to suppress damage to the flow paths. When the temperature is distributed differently throughout the member as the heat exchange target, it is possible to cause the temperature to be nearly uniformly distributed.

For example, in a case where the member as the heat exchange target is provided on the first wall section 1 and the temperature of the member is higher at the central portion side than at the periphery, as illustrated in Fig. 4(a), the flow path openings 4a to 4c on the cut plane may be disposed to be displaced gradually closer to the first wall section 1 side approaching the center than at the opposite ends. In this case, it is possible to reduce the temperature of the member on the central portion side by causing a fluid which is low in temperature to flow through the flow path and it is possible to cause the temperature to be nearly uniformly distributed throughout the member.

Meanwhile, for example, in a case where the member as the heat exchange target is provided on the first wall section 1 and the temperature of the member is higher at the periphery than at the central portion, as illustrated in Fig. 4(b), the flow path openings 4a to 4c on the cut plane may be disposed to be displaced gradually closer to the second wall section 2 side approaching the center than at the opposite ends. In this case, it is possible to reduce the temperature of the member at the periphery side by causing a fluid which is low in temperature to flow through the flow path and it is possible to cause the temperature to be nearly uniformly distributed throughout the member.

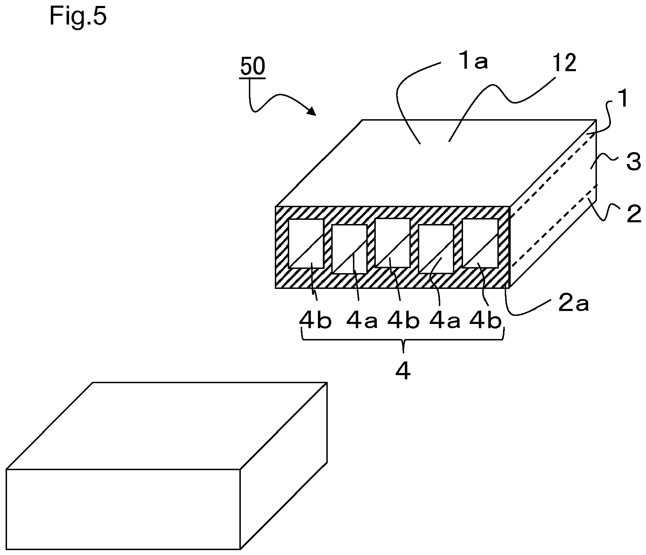

Fig. 5 is an external perspective view schematically illustrating a state of being cut from the first wall section to the second wall section as still another example of a flow path member which is not part of the present invention.

In the flow path member 50 according to the present example illustrated in Fig. 5, when all of the plurality of flow path openings on the cut plane are viewed, the flow path openings 4a and 4b are disposed to be displaced toward the first wall section 1 side or toward the second wall section 2 side alternately. According to such a configuration, it is possible to reduce the stress concentration between the corners of all the adjacent flow paths. Thus, since it is possible to suppress damage to the flow path, it is possible to improve the reliability of the flow path member 50. Further, it is possible to cause physical behavior to be dispersed from the main surface 1a of the first wall section 1 or from the main surface 2a of the second wall section 2 of the flow path member 50. Thus, since stress concentration due to an external factor is lowered and hence it is possible to suppress damage to the flow path, it is possible to improve the reliability of the flow path member 50.

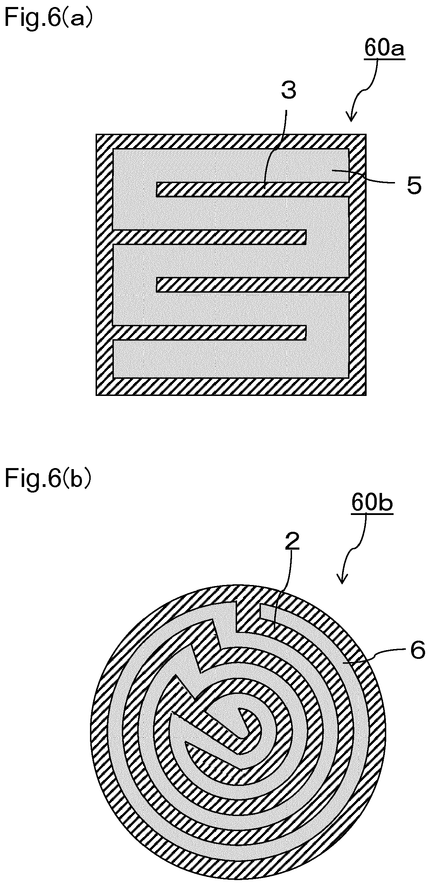

Fig. 6 shows cross-sectional views illustrating a cross section in parallel to the first wall section and the second wall section as still another example of the flow path member (a) is a meandering flow path, and (b) is a spiralling flow path.

In the flow path member 60 illustrated in Fig.6, a plurality of flow paths arranged in one direction on the cut plane is connected in the flow path member 60 and forms one flow path.

For example, when one inlet is provided and a fluid is distributed to a plurality of flow paths, the fluid is likely to flow through a flow path where pressure to the fluid is low, and thus there is a concern that heat exchange is performed unevenly. On the other hand, as illustrated in Fig. 6, when the flow paths are formed to be connected in the flow path member 60 as a single flow path, it is possible to cause the fluid to flow efficiently through the entire flow path. Accordingly, it is possible to improve the heat exchange efficiency between the member as the heat exchange target and the fluid. In addition, when the flow path is formed as a meandering flow path 5 illustrated in Fig. 6(a) or as a spiralling flow path 6 illustrated in Fig. 6(b), it is possible to cause the fluid to stay longer inside the flow path member 60. Therefore, it is possible to perform heat exchange efficiently.

In addition, a metal member is provided on at least one surface or in at least one interior section of the first wall section 1 and the second wall section 2 of the flow path members 10, 20, 30, 40, 50, and 60 according to the present example, and thereby a heat exchanger can be formed.

In such a heat exchanger, when a heat generating member is disposed on the main surface 1a or on the main surface 2a on which the metal member is provided, heat produced by the heat generating member is transmitted efficiently to the metal member, and the transmitted heat is further transmitted to the wall sections. Thus, it is possible to efficiently perform heat exchange with the fluid flowing through the flow path. Since the flow path members 10, 20, 30, 40, 50, and 60 according to the present example are highly reliable, the heat exchanger also becomes high in reliability. The heat exchanger according to the present example is particularly effective in a case where an electronic component is disposed, which includes a heat generating unit such as an LED element or a power semiconductor as the heat generating member.

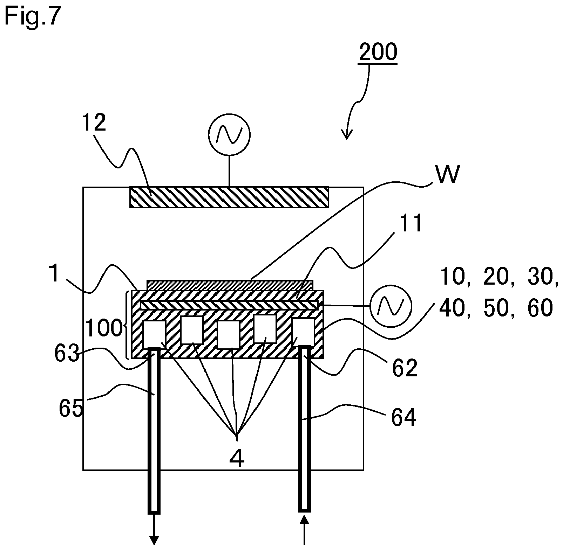

Fig. 7 is a view illustrating an example of a semiconductor manufacturing device including an heat exchanger.

In the example, the semiconductor manufacturing device 200 is a plasma processing device of a wafer W, and the wafer W is mounted on a heat exchanger 100 in which a metal member 11 is provided in the interior section of the first wall section 1 of the flow path members 10, 20, 30, 40, 50, and 60 according to the previous different examples. In the flow path members 10, 20, 30, 40, 50, and 60, an inlet 62 is connected to a supply tube 64, an outlet 63 is connected to a discharge tube 65, a fluid such as a gas or a liquid which is high or low in temperature is caused to circulate through the flow path provided in the flow path members 10, 20, 30, 40, 50, and 60, and thereby heating or cooling of the wafer W is performed.

In addition, an upper electrode 12 for generating plasma is provided above the wafer W, the metal member 11 in the interior section of the first wall section 1 of the flow path members 10, 20, 30, 40, 50, and 60 which configure the heat exchanger 100 is used as a lower electrode for generating plasma, a voltage is applied between the metal member 11 which is the lower electrode and the upper electrode 12, and thereby it is possible to cause plasma generated between the metal member 11 which is the lower electrode and the upper electrode 12 to be in contact with the wafer W. Since the heat exchanger 100 includes the flow path members 10, 20, 30, 40, 50, and 60 according to the previous examples, it is possible to maintain the temperature of the metal member 11 as the lower electrode which becomes high in temperature during the plasma process to be stable. In addition, since the temperature of the wafer W is also controlled, it is possible to perform a highly dimension-accurate process. In addition, the metal member 11 of the semiconductor manufacturing device 200 may be divided into a plurality of members and may be formed to be a bipolar electrode which has one electrode and the other electrode.

In addition, Fig. 7 illustrates an example in which the metal member 11 is used as the lower electrode for generating plasma; however, when the metal member 11 is heated by a current flowing therein, it is possible to control the temperature of the fluid.

Further, the first wall section 1 is formed of a dielectric material, then the metal member 11 is used as an electrode for electrostatic adsorption, and, when a voltage is applied to the metal member 11, it is possible to adsorb and hold the wafer W with an electrostatic adsorption force such as the Coulomb force or the Johnson Rahbeck force which is generated between the wafer W and the dielectric layer.

Thus, since the heat exchanger 100 according to the present example includes the metal member 11 provided in the interior section of at least one of the first wall section 1 and the second wall section 2 of the flow path members 10, 20, 30, 40, 50, and 60 according to the previous examples which are highly reliable, it is possible to achieve the heat exchanger 100 that is high in heat exchange efficiency and in reliability and thus that is durable in a long-term use.

Since the flow path members 10, 20, 30, 40, 50, and 60 according to the previous examples is good in durability and corrosion resistance, high in reliability, and high in heat exchange efficiency as described above, the semiconductor manufacturing device 200 including the flow path members according to the present example is capable of performing as an appropriate semiconductor manufacturing device which has little trouble when manufacturing or monitoring the semiconductor element. In addition, examples of the semiconductor manufacturing device 200 according to the present example include, in addition to the plasma processing device illustrated in Fig. 7 as an example thereof, a sputtering device, a resist applying device, a CVD device or an etching process device, and when these devices include the flow path members 10, 20, 30, 40, 50, and 60 according to the previous examples, it is possible for these device to achieve the above effect.

Hereinafter, an example of a method of manufacturing the flow path member according to the present example will be described. The following description is provided without reference signs for the flow path member except that the component is specialized as the aspect illustrated in Figs. 1 to 6.

First, in manufacturing the flow path member, a process is described, in which, after obtaining molded bodies of the first wall section 1 and a substrate (hereinafter, also simply referred to as a substrate) having a concave section which is integrally formed of the second wall section 2 and the third wall section 3, the first wall section 1 and the substrate are joined by a joining material, and thereby a molded body to become the flow path member is obtained.

A ceramic raw material of which a degree of purity is 90% or more and an average particle size is about 1 µm is prepared, a predetermined amount of a sintering additive, a binder, and a solvent, a dispersant and the like are added to the ceramic raw material, the mixed slurry is spray-dried and granulated using a spray granulation method (spray-drying method), and then a primary raw material is obtained. Next, the spray-dried and granulated primary raw material is put into a predetermined shape of a rubber die, molded by an isostatic pressing method (rubber-pressing method), then the molded body is removed from the rubber die, and a cutting process is performed.

During the cutting process, the molded body to become the substrate is processed to form a concave portion which configures an external appearance or a flow path into a predetermined shape and forms an inlet and an outlet of the fluid. Next, as the molded body to become the first wall section 1 of the flow path member, a green sheet may be prepared by being manufactured by the isostatic pressing method, a doctor blade method which is a common molding method of ceramics using slurry, or a roll compaction molding method after granulating the slurry. The cutting process is performed such that the molded body is fit into the molded body to become the substrate so as be able to provide a flow path.

Next, a process of joining the molded body to become the first wall section 1 to the molded body to become the substrate will be described. As the joining material to be used for joining, a joining material formed of slurry can be used, which is obtained by weighing and mixing the ceramic raw material, the sintering additive, the binder, the dispersant and the solvent which are used for manufacturing the molded body to become the first wall section 1 and the molded body to become the substrate. The joining material is applied to at least one joining portion of the molded body to become the first wall section 1 and the molded body to become the substrate and the two molded bodies are joined to each other, and thereby a joined molded body is obtained, in which the molded body to become the first wall section 1 and the molded body to become the substrate are joined integrally. The joined molded body is fired in an atmosphere in accordance with the ceramic raw material and thereby it is possible to obtain the flow path member according to the present example.

In addition, in another example of a manufacturing method, the molded body to become the first wall section 1 and the molded body to become the substrate are fired in an atmosphere in accordance with the ceramic raw material such that sintered bodies of the first wall section 1 and the substrate are obtained. Then, a joining material made of glass is applied on at least one joining portion of the sintered bodies of the first wall section 1 and the substrate such that the sintered bodies are integrally joined, then a heating process is performed, and thereby it is possible to obtain the flow path member according to the present example.

Next, a method of manufacturing the flow path member by an extrusion molding method will be described.

After a die with a desired shape is prepared and a molded body to become the flow path member is obtained by a known extrusion molding method, the flow path member can be formed to include a plurality of inlets and outlets by being fired.

In addition, as another example of a process of obtaining a molded body, a green sheet is formed by the doctor blade method which is a common molding method of ceramics using slurry or by the roll compaction molding method after granulating the slurry, and the molded bodies formed into a desired shape by a die may be stacked.

For example, as one example, as a method of producing the slurry, first, silicon carbide powder of which an average particle size is 0.5 µm to 2 µm and boron carbide and carboxylate as a sintering additive are prepared. The powders are weighed to contain, for example, 0.12% by weight to 1.4% by weight of the boron carbide powder, 1% by weight to 3.4% by weight of the carboxylate powder with respect to 100% by weight of the silicon carbide powder and then are mixed.

Next, the mixed powder, polyvinyl alcohol, polyethylene glycol, binder such as an acrylic resin or a butyral resin, water, and dispersant are put into a ball mill, a tumbling mill, a vibration mill, or a bead mill and are mixed. Here, an added amount of the binder is determined such that the molded body has appropriate strength or flexibility and during firing, attachment and detachment of binder for molding is sufficient, and the slurry produced as described above may be used.

The slurry produced as described above is used and a green sheet may be manufactured by the doctor blade method, or after the slurry is granulated, a green sheet may be manufactured by the roll compaction method. The plurality of green sheets may be stacked to form a desired flow path.

In addition, the same slurry as that used for manufacturing the green sheet is applied, as a joining, material on the joining surfaces of the green sheets, the green sheets are stacked, pressed by pressure of substantially 0.5 MPa through a flat plate-like pressurizer and then, is dried at room temperature of substantially 50°C to 70°C for substantially 10 hours to 15 hours.

Next, the stacked green sheets to become the flow path member are fired in, for example, a known pusher-type or roller-type continuous tunnel furnace and a batch furnace. A temperature for firing is different depending on the materials. For example, when silicon carbide is a main component, the stacked green sheets may be maintained in an inert gas atmosphere or in a vacuum atmosphere, at a temperature range of 1800°C to 2200°C for 10 minutes to 10 hours, and then may fired at a temperature range of 2200°C to 2350°C for 10 minutes to 20 hours.

In addition, as another method, for example, during the firing, the molded body obtained by any manufacturing method described above is mounted on a shelf which has a bow-like slope, or a weight which has a bow-like slope is placed on the molded body. In this way, the molded body is fired in a state in which the molded body is bent, and the first wall section 1 side and the second wall section 2 side are subjected to a grinding process or a polishing process such that the position displacement of the flow path may be changed with respect to the main surfaces 1a and 3a of the flow path member.

Here, for example, in order to form the metal member 11 on at least one of the first wall section 1 and second wall section 2 of the flow path member, aluminum or copper may be formed by a known printing method, or formed by an evaporation method, an aluminum plate or a copper plate may be joined using an active metal method or a brazing method, or a hole may be formed on a first lid section 1 and the hole may be filled with aluminum or copper. It is possible to obtain the heat exchanger 100 by forming as described above.

The flow path member according to the present example obtained as described above has flow paths of which adjacent flow paths are positioned to be displaced toward the first wall section 1 or toward the second wall section 2, and thereby the stress concentration between the corners of the adjacent flow paths is reduced. Thus, since the flow path is unlikely to be damaged, it is possible to obtain the flow path member of which the reliability is improved. In addition, particularly, the semiconductor manufacturing device 200 includes the heat exchanger 100 that has the flow path member according to the present example, and thereby it is possible to perform manufacturing or examining of the highly reliable semiconductor element.

### Reference Signs List

- 1: FIRST WALL SECTION
- 1a: MAIN SURFACE OF THE FIRST WALL SECTION
- 2: SECOND WALL SECTION
- 2a: MAIN SURFACE OF THE SECOND WALL SECTION
- 3: THIRD WALL SECTION
- 4, 4a, 4b, 4c, 4d, 4e: FLOW PATH OPENING
- 5, 6: FLOW PATH
- 10, 20, 30, 40, 50, 60: FLOW PATH MEMBER
- 61: WAFER
- 62: INLET
- 63: OUTLET
- 64: SUPPLY TUBE
- 65: DISCHARGE TUBE
- 100: HEAT EXCHANGER
- 200: SEMICONDUCTOR MANUFACTURING DEVICE

## Claims

1. A flow path member (40) comprising:
a first wall section (1);
a second wall section (2); and
a third wall section (3) that is provided between the first wall section (1) and the second wall section (2),
wherein an internal section that is configured by the first wall section (1), the second wall section (2), and the third wall section (3) becomes a flow path through which a fluid flows and a plurality of flow path openings (4) of the flow path are arranged in one direction on a cut plane obtained by cutting from the first wall section (1) to the second wall section (2), and
wherein one of two adjacent flow path openings (4) is disposed to be more displaced than the other either toward the first wall section (1) side or toward the second wall section (2) side,
**characterized in that**, when all of the plurality of flow path openings (4) on the cut plane are viewed, the flow path openings (4) are disposed to be displaced gradually closer either to the first wall section (1) side or to the second wall section (2) side approaching a center of the arrangement of all of the plurality of flow path openings (4) starting from opposite ends of the arrangement of all of the plurality of flow path openings (4).

2. The flow path member according to claim 1,
wherein the central portion of at least one of the first wall section (1) and the second wall section (2) that configures the flow path is curved toward the flow path side.

3. A heat exchanger (100) comprising:
a metal member (11) that is provided on at least one surface or in at least one interior section of the first wall section (1) and the second wall section (2) of the flow path member according to claim 1 or 2.

4. A semiconductor manufacturing device (200) comprising:
a heat exchanger (100) in which a metal member (11) is provided in at least one interior section of the first wall section (1) and the second wall section (2) of the flow path member according to claim 1 or 2 and the metal member (11) is an electrode for adsorbing a wafer.

## Patentansprüche

1. Strömungspfadelement (40), aufweisend:
einen ersten Wandabschnitt (1),
einen zweiten Wandabschnitt (2) und
einen dritten Wandabschnitt (3), der zwischen dem ersten Wandabschnitt (1) und dem zweiten Wandabschnitt (2) vorgesehen ist,
wobei ein Innenabschnitt, der durch den ersten Wandabschnitt (1), den zweiten Wandabschnitt (2) und den dritten Wandabschnitt (3) konfiguriert ist, zu einem Strömungspfad wird, durch den ein Fluid strömt, und eine Mehrzahl von Strömungspfadöffnungen (4) des Strömungspfades in einer Richtung auf einer Schnittebene angeordnet ist, die durch Schneiden von dem ersten Wandabschnitt (1) aus zu dem zweiten Wandabschnitt (2) erhalten wird, und
wobei eine von zwei benachbarten Strömungspfadöffnungen (4) angeordnet ist, um entweder in Richtung zu der erster-Wandabschnitt- (1) Seite oder in Richtung zu der zweiter-Wandabschnitt- (2) Seite mehr als die andere verlagert zu sein,
**dadurch gekennzeichnet, dass**,
wenn alle der Mehrzahl von Strömungspfadöffnungen (4) auf der Schnittebene betrachtet werden, die Strömungspfadöffnungen (4) angeordnet sind, um allmählich näher entweder zu der erster-Wandabschnitt- (1) Seite oder zu der zweiter-Wandabschnitt- (2) Seite verlagert zu sein, während eines Näherns einer Mitte der Anordnung aller der Mehrzahl von Strömungspfadöffnungen (4) beginnend von entgegengesetzten Enden der Anordnung aller der Mehrzahl von Strömungspfadöffnungen (4).

2. Strömungspfadelement gemäß Anspruch 1,
wobei der zentrale Abschnitt von mindestens einem von dem ersten Wandabschnitt (1) und dem zweiten Wandabschnitt (2), der den Strömungspfad konfiguriert, in Richtung zu der Strömungspfadseite gekrümmt ist.

3. Wärmetauscher (100), aufweisend:
ein Metallelement (11), das auf mindestens einer Fläche oder in mindestens einem Innenabschnitt des ersten Wandabschnitts (1) und des zweiten Wandabschnitts (2) des Strömungspfadelements gemäß Anspruch 1 oder 2 vorgesehen ist.

4. Halbleiterherstellungsvorrichtung (200), aufweisend:
einen Wärmetauscher (100), in dem ein Metallelement (11) in mindestens einem Innenabschnitt des ersten Wandabschnitts (1) und des zweiten Wandabschnitts (2) des Strömungspfadelements gemäß Anspruch 1 oder 2 vorgesehen ist, und das Metallelement (11) eine Elektrode zum Adsorbieren eines Wafers ist.

## Revendications

1. Un élément de trajet d'écoulement (40), comprenant :
une première section de paroi (1) ;
une deuxième section de paroi (2) ; et
une troisième section de paroi (3) qui est prévue entre la première section de paroi (1) et la deuxième section de paroi (2),
dans lequel une section interne qui est configurée par la première section de paroi (1), la deuxième section de paroi (2) et la troisième section de paroi (3) devient un trajet d'écoulement à travers lequel un fluide s'écoule et une pluralité d'ouvertures de trajet d'écoulement (4) sont disposées dans une direction sur un plan de coupe obtenu en coupant de la première section de paroi (1) à la deuxième section de paroi (2), et
dans lequel une de deux ouvertures de trajet d'écoulement (4) adjacentes est disposée de manière à être plus déplacée que l'autre, soit vers le côté de première section de paroi (1), soit vers le côté de deuxième section de paroi (2),
**caractérisé en ce que**,
lorsque l'ensemble de la pluralité d'ouvertures de trajet d'écoulement (4) sont vues sur le plan de coupe, les ouvertures (4) de trajet d'écoulement sont disposées de manière à se rapprocher progressivement soit du côté de première section de paroi (1), soit du côté de deuxième section de paroi (2), en s'approchant d'un centre de l'agencement de l'ensemble des ouvertures de trajet d'écoulement(4) à partir d'extrémités opposées de l'agencement de l'ensemble de la pluralité d'ouvertures de trajet d'écoulement (4).

2. L'élément de trajet d'écoulement selon la revendication 1,
dans lequel la partie centrale d'au moins une des première section de paroi (1) et deuxième section de paroi (2) configurant le trajet d'écoulement est incurvée vers le côté de trajet d'écoulement.

3. Un échangeur de chaleur (100), comprenant :
un élément métallique (11) qui est prévu sur au moins une surface ou dans au moins une section intérieure de la première section de paroi (1) et de la deuxième section de paroi (2) de l'élément de trajet d'écoulement selon la revendication 1 ou 2.

4. Un dispositif de fabrication de semi-conducteur (200), comprenant :
un échangeur de chaleur (100) dans lequel un élément métallique (11) est prévu dans au moins une section intérieure de la première section de paroi (1) et de la deuxième section de paroi (2) de l'élément de trajet d'écoulement selon la revendication 1 ou 2, et l'élément métallique (11) est une électrode pour adsorber une plaquette.
